# EUROPEAN PATENT SPECIFICATION

(11) **EP 0 417 522 B1**
(45) Date of publication and mention of the grant of the patent: **19.01.2000**
(21) Application number: 90116152.1
(22) Date of filing: 23.08.1990
(51) Int. Cl.: H01L 21/285, H01L 21/3205

(54) **Method for forming protective barrier on silicided regions**
Verfahren zum Herstellen einer Schutzsperre aus Silicidzonen
Procédé de fabrication de barrière de protection sur des zones silicidées

(30) Priority: 11.09.1989 US 405703
(43) Date of publication of application: 20.03.1991
(73) Proprietor: TEXAS INSTRUMENTS INCORPORATED, Dallas Texas 75265 (US)
(72) Inventor: Spratt, David B., Plano, Texas 75075 (US); Eklund, Robert H., Plano, Texas 75023 (US)
(74) Representative: Leiser, Gottfried, Dipl.-Ing.

(56) References cited:
- EP-A- 0 325 808
- US-A- 4 141 022
- IBM TECHNICAL DISCLOSURE BULLETIN. vol. 24, no. 4, September 1981, NEW YORK US pages 1970 - 1973; OSBURN ET AL: 'self-aligned silicide conductors in FET integrated circuits'
- PATENT ABSTRACTS OF JAPAN vol. 7, no. 154 (E-185)6 July 1983

## Description

### FIELD OF THE INVENTION

The present invention relates to the field of integrated circuit manufacturing techniques. More specifically, the present invention relates to methods for forming a protective layer in an integrated circuit.

### BACKGROUND OF THE INVENTION

In order to provide smaller components in integrated circuit devices, it has been found necessary to provide shallower doped regions (i.e., sources, drains, etc.) in order to raise the breakdown voltage level between nearby junctions. In addition, shallower junctions provide less diffusion of dopant into the integrated circuit substrate and thus minimize the chances of shorts between doped regions.

However, the conductivity of doped regions is proportional to the area of the doped region perpendicular to current flow. With shallower junctions, the resistivity of the doped regions is increased. This causes slower circuit operation and higher power consumption.

To combat the lowered resistance of shallow diffusions, the formation of highly conductive regions on the surface of diffusions has been employed. For example, in Tasch, et al., U.S. Patent No. 4,384,301, issued May 17, 1983, and assigned to the assignee of this application, Titanium disilicide regions are formed in a self-aligned manner onto silicon regions. Thus a highly conductive region on the surface of diffusions is formed. However, in order to form interconnections to the diffusions, an insulating layer formed over these diffusions must be etched to provide a via from the top surface of this insulating layer to the diffusion itself. The titanium silicide layers and the diffusion are both relatively thin. During the etching of the via in the interlevel insulating layer, the etching attacks the surface of the titanium silicide in the diffusion. In some instances, this can etch through the diffused region and thus a failure in the integrated circuit. This example and other situations show the need for forming a protective layer on the surface of silicided regions in integrated circuitry.

In PATENT ABSTRACT OF JAPAN; vol. 7, no. 154 (E-185) & JP-A-58 063 165 a method for forming a silicide layer is known. According to this method the silicide layer is formed by sputter deposition and must be masked and etched.

In EP-A-0 325 808 a method of forming an interconnection structure is described wherein an upper barrier layer is formed on a titanium silicide layer by selective deposition of tungsten or molybdenum, which emerge from chemical reduction of a hexafluoride of tungsten or molybdenum by hydrogen. However, the titanium silicide layer is attacked by the reduction of a hexafluoride by hydrogen. In order to avoid degradation of the titanium silicide layer, a thin film of titanium nitride may be created by annealing of the titanium silicide layer in a nitrogen environment before deposition of tungsten or molybdenum. Another possibility of protecting the titanium silicide layer is to use a mixture of hexafluoride and silane in a certain ratio.

In US-A-4 141 022 a metal contact system for an IGFET is described. This method requires masking and etching of a titanium-tungsten layer along with a sputter deposited platinium silicide layer. It is not shown in which manner contact silicidation can be achieved onto another metal silicide layer.

From US-A-4,619,035 a method of manufacturing a semiconductor device provided with Schottky barrier diodes having different forward voltages on one substrate is known. The method comprises a step of forming at least one Schottky barrier diode of a first kind, by placing a first metal layer at a first surface part of a silicon substrate, and then by silicifying the first metal layer, and a step of subsequently forming at least one Schottky barrier diode of a second kind, by placing, at a second surface part of the silicon substrate which is different from the first surface part, a second metal layer which consists of a metal different from the metal of which the first metal layer consists and then by silicifying the second metal layer. The second metal layer may be applied to coat the first surface part of the silicon substrate in addition to the second surface part of the silicon substrate.

### SUMMARY OF THE INVENTION

In accordance with the present invention methods for forming a protective layer in an integrated circuit comprising the steps defined in claims 1 and 8 are provided.

In the primary described embodiment, a titanium silicide layer is formed in integrated circuitry using self-aligned techniques. Local interconnection layers may be formed using biproducts of the self-aligned titanium disilicide formation. A layer of another siliciding metal, for example platinum, is then formed overall. The platinum layer is then subjected to an annealing step which causes a portion of the silicon in the titanium disilicide layers to react with the platinum to form platinum silicide. This platinum silicide layer is formed in a self-aligned manner on the surface of the silicided regions. The platinum silicide layer serves to protect the under-lying titanium disilicide layer from subsequent etching steps or other harmful processing operations.

### DESCRIPTION OF THE DRAWINGS

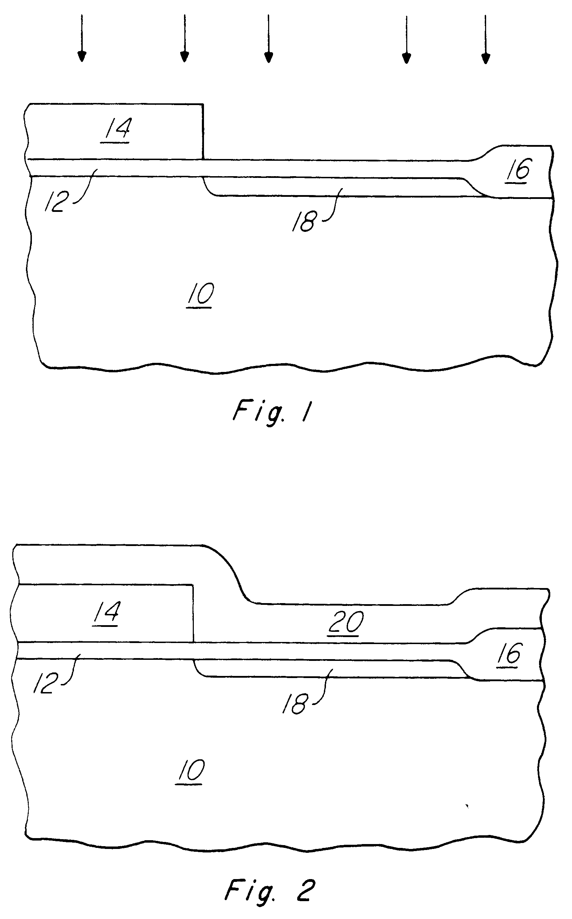

Figures 1 through 10 are sideview schematic diagrams showing the processing steps of a preferred embodiment of the present invention wherein a platinum silicide protective layer is formed on the surface of a titanium disilicide region.

### DETAILED DESCRIPTION

Figures 1 through 10 are sideview schematic diagrams showing a preferred embodiment of the present invention. In Figures 1 through 10, a protective layer is formed on the surface of a source/drain of a field effect transistor. As will become apparent to those skilled in the art in light of this specification, the use of the invention is not limited to that of source/drains in field effect transistors or to field effect transistors at all. The invention has wide applicability in all areas of integrated circuit fabrication.

Figure 1 shows the initial steps of the preferred embodiment. Substrate 10 is a crystalline silicon substrate. Substrate 10 is a P type substrate in the described embodiment, however the doping type of the substrate does not play a significant part in the present process. For example, substrate 10 could be N type. Thick field silicon dioxide region 16 is formed by local oxidation of silicon using a process such as that shown in Havemann, et al., U.S. Patent No. 4,541,167, issued September 17, 1985 and assigned to the assignee of this application. Substrate 10 is then subjected to thermal oxidation in a steam environment for approximately 7 minutes at a temperature of approximately 850 °C to form silicon dioxide layer 12 as shown in Figure 1. Polycrystalline silicon layer 14 is then deposited using chemical vapor deposition to a thickness of approximately 4,500 Angstroms. Polycrystalline silicon layer 14 is then patterned using common photolithographic techniques. The structure of Figure 1 is then subjected to an ion implantation of phosphorous ions having a density of approximately 2 x 10¹³ ions per centimeter² and an energy of approximately 80 kiloelectron volts. This ion implantation is annealed to form lightly doped region 18 as shown in Figure 1. Lightly doped region 18 is selected as an N type region to be opposite with the doping level of substrate 10. The doping type or level of this doped region does not impact practice of the invention itself but is specific to the described embodiment of the invention.

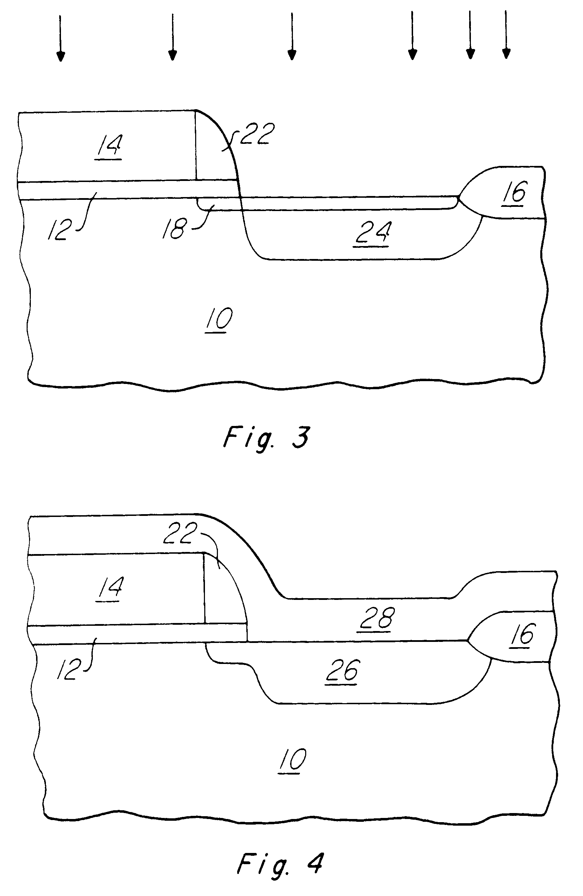

A layer of silicon dioxide 20 is the formed on the surface of the structure of Figure 1 as shown in Figure 2. Silicon dioxide layer 20 is conformally deposited using low pressure chemical vapor deposition. Silicon dioxide layer 20 is then etched using a mixture of oxygen, C₂F₆, CHF₃ and helium. The etching is conducted until the portion of silicon dioxide layer 12 overlying doped region 18 is cleared as shown in Figure 3. In addition, silicon dioxide sidewall layer 22 is formed because of the nature of anisotropic etching. The resulting structure is shown in Figure 3. The structure of Figure 3 is subjected to a double ion implantation of arsenic and phosphorous ions. The arsenic ions are implanted at a density of approximately 3 x 10¹⁵ ions per centimeter² and an energy of approximately 150 kiloelectron volts.The phosphorous ions are implanted at a density of approximately 4 x 10¹⁴ ions per centimeter² and an energy of approximately 85 kiloelectron volts. This ion implantation forms doped region 24 as shown in Figure 3.

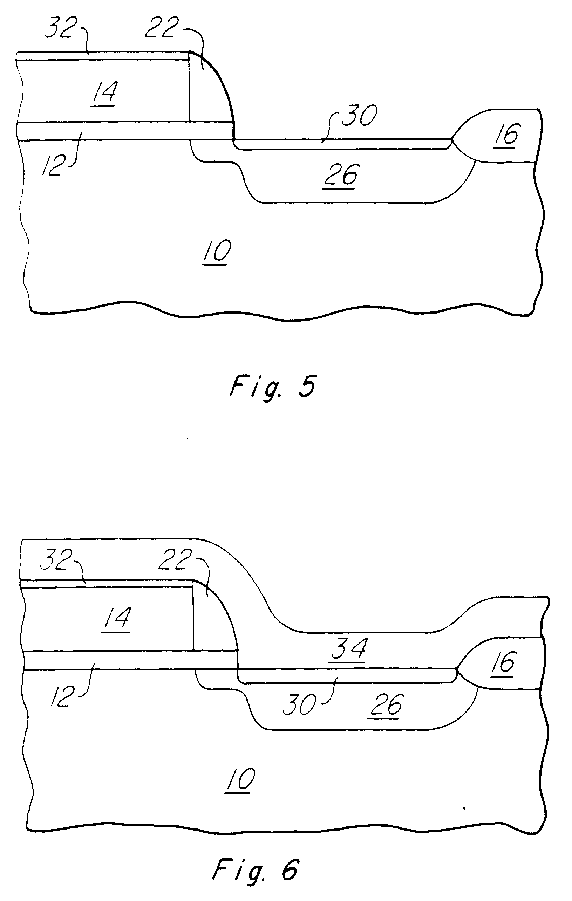

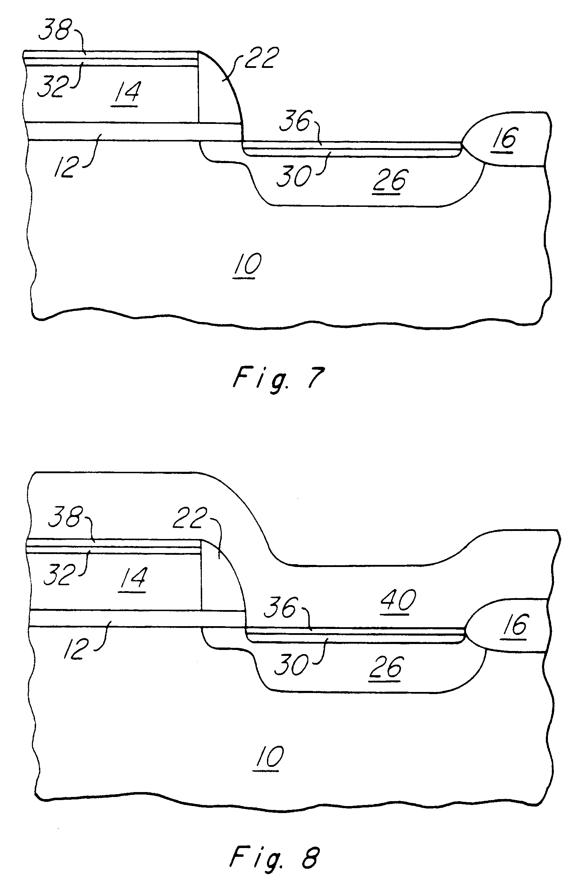

A layer of titanium is then deposited by sputter deposition in a surface of the structure of Figure 3 as shown in Figure 4. Lightly doped region 18 and doped region 24 are combined to provide source/drain region 26 for convenience of description. The structure of Figure 4 is then subjected to an annealing process at a temperature of approximately 625°C to 675°C in a nitrogen environment. A portion of titanium layer 28 reacts with silicon substrate 10 and polycrystalline silicon gate 14 to form titanium disilicide regions 30 and 32 as shown in Figure 5. The unreacted portion of titanium layer 28 reacts with the nitrogen environment to form titanium nitride. This process is described in more detail in Lau, U.S. Patent No. 4,545,116, issued October 8, 1985 and assigned to the assignee of this application. The titanium nitride is removed by wet etching leaving titanium disilicide layers 30 and 32 as shown in Figure 5. A layer of platinum 34 is then deposited on the surface of the structure of Figure 5 as shown in Figure 6. The structure of Figure 6 is then subjected to an annealing step, preferably in a low temperature of approximately 450°C to 525°C but temperatures of up to 600°C may be advantageously used. The lower temperature anneal is selected to minimize diffusion of dopants in source/drain 26, for example. Other temperatures and a wide range of anneal times may be used, but the lower temperature is preferred. The unreacted portion of platinum layer 34 is then removed by wet etching in aqua regia leaving the structure of Figure 7 having platinum silicide regions 36 and 38. Platinum silicide regions 36 and 38 are approximately 150 Angstroms thick and are formed along the exposed portions of titanium disilicide regions 30 and 32. Platinum silicide is more robust than titanium disilicide. Thus, platinum silicide regions 36 and 38 provide a protective layer over titanium disilicide regions 30 and 32.

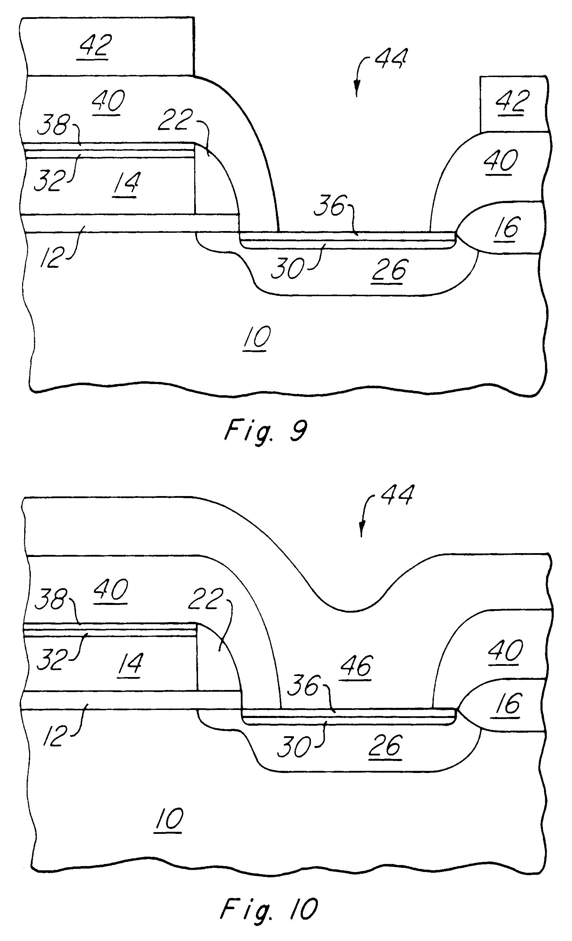

An inter-level oxide layer 40 is then deposited on the surface of the structure of Figure 7 to a thickness of approximately 10,000 Angstroms using low pressure chemical vapor deposition. A layer of photoresist is formed and patterned on the structure of Figure 8 as shown in Figure 9. Photoresist 42 provides an etch mask for the formation of via 44 which provides an opening to the surface of platinum silicide layer 36. Silicon dioxide layer 40 is etched using a mixture of oxygen, C₂F₆, CHF₃ and helium. Because this etching process is highly selective to platinum silicide, and is less selective to titanium disilicide, platinum silicide layer 36 provides a protective layer to protect the integrity of not only titanium disilicide layer layer 30 but source/drain region 26. In the absence of platinum silicide layer 36, formation of via 44 might etch completely through titanium disilicide layer 30 and source/drain region 26 to substrate 10. Photoresist layer 42 is then removed using common ashing and wet removal techniques and a conductive layer 46, for example a tungsten layer, is deposited on the surface of inter-level oxide layer 40 and into via 44 to provide contact at a surface of platinum silicide surface 36. If during the formation of via 44, titanium disilicide layer 30 and source/drain region 26 were etched through to substrate 10, conductive layer 46 would make direct contact to substrate 10 and the circuit containing the portion of Figure 10 would be inoperable.

Although specific embodiments of the present invention are herein described, they are not to be construed as limiting the scope of the present invention. For example, although the preferred embodiment shows the use of protective platinum silicide layer 36 on the surface of titanium disilicide layer 30, platinum layer 36 can provide protective functions in other circumstances than the formation of vias to doped regions. For example, platinum silicide layer 38 may provide protection for titanium disilicide layer 32 during planarization of interlevel oxide layer 40 on the surface of the integrated circuit. Many embodiments of the present invention will become clear to those skilled in the art in light of the teachings of the specification. The scope of the invention is limited only by the claims appended hereto.

## Claims

1. A method for forming a protective layer in an integrated circuit, comprising the steps of:
providing a silicon substrate;
forming and patterning a protective layer on said substrate;
depositing a layer of first siliciding metal overall;
reacting said first siliciding metal with said substrate where said substrate is not covered by said protective layer to form a first metal silicide;
removing the unreacted portion of said first siliciding metal;
depositing a layer of second siliciding metal overall;
reacting said second siliciding metal with said first metal silicide to form a second metal silicide, said second metal silicide being chosen to protect the underlying silicide layer from subsequent etching steps; and
removing the unreacted portion of said layer of second siliciding metal.

2. A method as in claim 1 wherein said silicon substrate is a single crystal silicon substrate.

3. A method as in claim 1 wherein said protective layer comprises silicon dioxide.

4. A method as in claim 1 wherein said first siliciding metal is titanium.

5. A method as in claim 1 wherein said second siliciding metal is platinum.

6. A method as in claim 1 wherein said first siliciding metal is titanium and said second siliciding metal is platinum.

7. A method as in claim 1 wherein said reacting of said second siliciding metal is performed by heating to a temperature of less than 600° Celsius.

## Patentansprüche

1. Verfahren zum Bilden einer Schutzschicht in einer integrierten Schaltung mit den Schritten:
Bereitstellen eines Siliciumsubstrats,
Bilden und Strukturieren einer Schutzschicht auf dem Substrat,
Aufbringen einer Schicht aus einem ersten Silicid bildenden Metall über alles,
Reagieren des ersten Silicid bildenden Metalls mit dem Substrat, wo das Substrat nicht mit der Schutzschicht bedeckt ist, unter Bildung eines ersten Metallsilicids,
Entfernen des nicht reagierten Teils des ersten Silicid bildenden Metalls,
Aufbringen einer Schicht aus einem zweiten Silicid bildenden Metall über alles,
Reagieren des zweiten Silicid bildenden Metalls mit dem ersten Metallsilicid unter Bildung eines zweiten Metallsilicids, wobei das zweite Metallsilicid so ausgewählt wird, daß die darunterliegende Silicidschicht vor nachfolgenden Ätzschritten geschützt wird, und
Entfernen des nicht reagierten Teils der Schicht aus dem zweiten Silicid bildenden Metall.

2. Verfahren nach Anspruch 1, wobei das Siliciumsubstrat ein Einkristall-Siliciumsubstrat ist.

3. Verfahren nach Anspruch 1, wobei die Schutzschicht Siliciumdioxid enthält.

4. Verfahren nach Anspruch 1, wobei das erste Silicid bildende Metall Titan ist.

5. Verfahren nach Anspruch 1, wobei das zweite Silicid bildende Metall Platin ist.

6. Verfahren nach Anspruch 1, wobei das erste Silicid bildende Metall Titan ist und das zweite Silicid bildende Metall Platin ist.

7. Verfahren nach Anspruch 1, wobei das Reagieren des zweiten Silicid bildenden Metalls durch Erwärmen auf eine Temperatur von weniger als 600 °C ausgeführt wird.

## Revendications

1. Procédé pour former une couche protectrice dans un circuit intégré, comprenant les étapes consistant à:
prendre un substrat en silicium;
former et structurer une couche protectrice sur ledit substrat;
déposer sur l'ensemble une couche d'un premier métal formant un siliciure;
faire réagir ledit premier métal formant un siliciure avec ledit substrat, à l'endroit où ledit substrat n'est pas recouvert par ladite couche protectrice pour former un premier siliciure métallique;
éliminer les parties, qui n'ont pas réagi, dudit premier métal formant un siliciure;
déposer sur l'ensemble une couche d'un second métal formant un siliciure;
faire réagir ledit second métal formant un siliciure avec ledit premier siliciure métallique pour former un second siliciure métallique, ledit second siliciure métallique étant choisi pour protéger la couche de siliciure sous-jacente vis-à-vis d'étapes suivantes d'attaque chimique; et
retirer la partie, qui n'a pas réagi, de ladite couche du second métal formant un siliciure.

2. Procédé selon la revendication 1, selon lequel ledit substrat en silicium est un substrat en silicium monocristallin.

3. Procédé selon la revendication 1, selon lequel ladite couche protectrice comprend du dioxyde de silicium.

4. Procédé selon la revendication 1, selon lequel le premier métal formant un siliciure est le titane.

5. Procédé selon la revendication 1, selon lequel ledit second métal formant un siliciure est le platine.

6. Procédé selon la revendication 1, selon lequel ledit premier métal formant un siliciure est le titane et ledit second métal formant un siliciure est le platine.

7. Procédé selon la revendication 1, selon lequel ladite réaction dudit second métal formant un siliciure est exécutée par chauffage à une température inférieure à 600° Celsius.
